# EUROPEAN PATENT SPECIFICATION

(11) **EP 0 376 365 B1**
(45) Date of publication and mention of the grant of the patent: **09.08.1995**
(21) Application number: 89203004.0
(22) Date of filing: 27.11.1989
(51) Int. Cl.: H01L 23/367, H01L 23/373

(54) **Semiconductor module**
Halbleitermodul
Module semi-conducteur

(30) Priority: 01.12.1988 NL 8802958; 01.12.1988 NL 8802957
(43) Date of publication of application: 04.07.1990
(73) Proprietor: Akzo Nobel N.V., 6824 BM Arnhem (NL)
(72) Inventor: van Andel, Eleonoor, NL-7666 LK Fleringen (NL); Dirix, Carolina Anna Maria Christina, NL-6932 BR Westervoort (NL)
(74) Representative: Schalkwijk, Pieter Cornelis, c.s.

(56) References cited:
- EP-A- 0 065 686
- EP-A- 0 269 065
- EP-A- 0 285 779
- NL-C- 110 715
- PATENT ABSTRACTS OF JAPAN, vol. 8, no. 44 (E-229)[1481], 25 February 1984 & JP-A-58 200 560
- IBM TECHNICAL DISCLOSURE BULLETIN, vol. 21, no. 5, October 1978, page 1857, NewYork, US; R.G. DESSAUER et al.: "Brush-tipped piston for thermal conduction"
- ELECTRONICS & POWER, vol. 18,Juni 1972, page 235, Hitchen, GB; "Spherical diamond heatsinks"

## Description

The invention relates to a semiconductor module comprised of at least one semiconductor chip, at least one heat dissipating conductor unit, such as a heat spreader plate, connected to the back side of said semiconductor chip, and a plurality of closely spaced cooling fins of a high thermal conductive material, said cooling fins being attached to the side of the heat dissipating conductor unit facing away from said semiconductor chip, and said cooling fins projecting away from said semiconductor chip, wherein said cooling fins are positioned in cooling fin groups separated from each other by interspaces having a longitudinal direction substantially parallel to said heat dissipating conductor unit, said cooling fin groups being adapted to provide fluid communication between adjacent interspaces, said interspaces alternately being inlets and outlets for the flow of coolant through said cooling fin groups.

Such a semiconductor module, also called a multichip module, is generally known. In such semiconductor modules the transfer of heat generated in the device in operation commonly presents a problem.
Each chip consisting of, say, monocrystalline silicon with dimensions of about 0.5-1 cm² and a thickness of some tens to several hundreds of microns, as a rule contains a few million transistors generating heat in operation. The transistors generally are positioned in or near one main surface of the chip. The removal of heat is to take place from the side opposite to the main surface. What solutions have been found so far for dissipating heat in multichip modules is described in detail in the article "Thermal Management of Air- and Liquid-Cooled Multichip Modules" in IEEE Transactions on Components, Hybrids and Manufacturing Technology, Vol. CHMT-10, No. 2, June 1987, pp. 159-175. Said article shows that more satisfactory results are attained using water cooling than using air cooling, which is not inconceivable considering that air is essentially a poor coolant. Nevertheless, preference is often given to air cooling on account of the medium's superior handleability.

The invention has for its object to provide a semiconductor module of the type described in the opening paragraph, which is known from EP-A-0285779. In this known apparatus the cooling fin groups comprise a large number of parallel plates of a high thermal conductive material. The cooling air is fed to the upper side of the cooling fin groups. For that reason, the coolant descharge channels or interspaces are covered with special arched ducts, which with their bottom walls are mounted at the top of the vulnerable thin plate fins. To keep the large number of thin plate fins parallel, spacers are provided at the top and bottom ends of the plate fins. Though suitable results may be obtained with the apparatus according to EP-A-0285779, its construction is relatively complicated. Further, because of the plate type cooling fins it will be difficult to obtain the required great heat dissipation in a limited area.

The invention has for its object to provide a semiconductor module of the type described in the opening paragraph constructed so that superior cooling to that of the known modules is made feasible, and even in air cooling more favourable results are attained than could previously be obtained by using water cooling. The semiconductor module according to the invention is characterized in that said cooling fin groups comprise closely spaced wires.

A simple and practical embodiment of the semiconductor according to the invention is characterized in that said interspaces for coolant supply each comprise a coolant inlet at the front end and are closed at the rear end, whereas said interspaces for coolant discharge are closed at said front end and comprise a coolant outlet opening at said rear end.

According to the invention, a preferred embodiment of the semiconductor module is characterized in that measured transverse to their longitudinal direction, the interspaces that are inlets for the flow of coolant throught the cooling fin groups have a decreasing cross-section in the coolant feed direction and the interspaces that are outlets for the flow of coolant through the cooling fin groups have an increasing cross-section in the coolant discharge direction.

An especially effective embodiment of the semiconductor module is characterized according to the invention in that the cooling fin groups each consist of a plurality of wire cooling fins, which from their place of attachment at the heat spreader plate are oriented or bent toward each other in the plane transverse to the longitudinal direction of the groups. In that case according to the invention the cooling fins in a group oriented or bent toward each other are of different lengths and with their outer circumference form a triangle, with the vertical sides of the triangle bounding said interspaces. Although the cooling fins according to the invention are arranged in specially formed groups of, for instance, approximately triangular cross-section and with similarly shaped interspaces, according to the invention the wire cooling fins of all cooling fin groups are distributed uniformly at the surface of the heat sink with such places of attachment at the heat sink forming, for instance, a pattern of connecting equilateral triangles. The semiconductor module according to the invention is advantageously characterized in that the crests of adjacent cooling fin groups extend relative to the heat spreader plate by a zig-zag pattern. Another substantial improvement in heat transfer can be achieved when according to the invention there is positioned at the crest of each of the cooling fin groups a baffle extending in longitudinal direction of the cooling fin groups, such that adjacent baffles, preferably consisting of strips of foil, together with said interspaces form inlet or outlet channels for the coolant.

An effectively cooled semiconductor module is characterized according to the invention in that, measured transverse to their longitudinal direction and at their place of attachment at the heat spreader plate, the maximum width of each of the cooling fin groups is less than the average length of the module's semiconductor chips. This latter aspect enables cooling to take place in such a way that each chip of the entire system has virually the same temperature and is cooled with fresh cooling air. A semiconductor module intended to be used for cooling with a gaseous coolant, more particularly air, is characterized according to the invention in that said maximum width of each of the cooling fin groups at the base is 1-9 mm, preferably 3-6 mm. A semiconductor module intended to be used for cooling with a liquid coolant, more particularly water, according to the invention is characterized with advantage in that said maximum width of each of the cooling fin groups at the base is 1-2 mm.

A semiconductor module having satisfactory heat dissipation is characterized according to the invention in that the wire cooling fins are mounted to the heat sink at a relative centre distance of 0,05-3 mm and have a diameter of at least 20 »m to 1000 »m. A favourable embodiment of the semiconductor module is characterized according to the invention in that the distance h from the crest of the cooling fin groups to the heat sink has the value 0.05 H < h < H, wherein H is the distance from the top edge of the baffles to the heat sink.

Further, the present invention relates to a heat exchanger comprising a heat dissipating conductor unit, such as a metal heat spreader plate, which is provided with a plurality of projecting closely spaced cooling fins of a high thermal conductive material, said cooling fins are positioned in cooling fin groups separated from each other by interspaces, said interspaces alternately being inlets and outlets for the flow of coolant through said cooling fin groups, characterized in that said cooling fin groups comprise closely spaced wires. According to the invention, this heat exchanger is characterized in that measured transverse to their longitudinal direction, the interspaces that are inlets for the flow of coolant through the cooling fin groups have a decreasing cross-section in the coolant feed direction, and the interspaces that are outlets for the flow of coolant through the cooling fin groups have an increasing cross-section in the coolant discharge direction. Preferably, the heat exchanger according to the invention is characterized in that the cooling fin groups each consist of a plurality of wire cooling fins, which from their place of attachment at the heat spreader plate are oriented or bent toward each other in the plane transverse to the longitudinal direction of said groups. An effective embodiment of the heat exchanger according to the invention is characterized in that the crests of adjacent cooling fin groups extend relative to the heat spreader plate by a zig-zag pattern. An advantageous embodiment of the heat exchanger according to the invention is characterized in that there is positioned at the crest of the cooling fin groups a baffle extending in longitudinal direction of the cooling fin groups, such that adjacent baffles, preferably consisting of strips or foil, together with said interspaces form inlet and outlet channels for the coolant.

Cooling of the semiconductor module according to the invention is preferably carried out using cooling air, although, in principle, use may also be made of some other cooling fluid. The coolant is fed to the gradually narrowing interspaces between the groups of cooling fins in the form of thin wires. Since said interspaces between the groups, and also the spaces between the foil baffles, are narrowing, the coolant is forced to flow between the cooling fins in the form of metal wires arranged into groups. On account of the very high number of, say, 1000 metal wires per cm² it is possible, therefore, to attain a high heat removal of the order of 450 kW/m². The coolant travels a long labyrinthine path between the plurality of wire cooling fins, which results in the module according to the invention having a particularly favourable cooling action.

In the device according to the invention it is of importance for the heat generated in a chip to be removed as rapidly as possible. Therefore, the thermal path from chip to coolant should be as short as possible. In addition, however, proper electrical insulation should be provided between the metal heat dissipation spreader plate and the back side of each chip. Of course, the metal heat spreader plate in a module will generally be in contact with ground. Often it is not desired that a chip's back side is grounded. As electrical insulators with high thermal conductivity may be mentioned crystalline bodies, such as diamond, cubic boron nitride, and the like.

Such crystals, however, are hard and brittle and poorly suited to be used as sole intermediate ply between the chip surface, which also is hard, and the hard metal sheet. In the module according to the invention use is preferably made of a sandwich element in the form of an intermediate ply between chips and metal sheet, which is built up of a thin layer of a soft metal on the metal heat spreader plate, a corresponding layer of metal on the chips' surface, and a layer of a polymer material between the two soft metal layers, with there being incorporated into the polymer material some amount of grains of diamond crystals or similar material of an average dimension larger than the thickness of the polymer layer. As their dimensions exceed the thickness of the polymeric layer, the crystals penetrate into the soft metal layers on either side, so that there is no polymer material between metal and crystal. Thus favourable thermal conduction is realised from chip to metal sheet. In employing diamond crystals it was found that, if only ten per cent of the contact surface is metal/diamond/metal contact, the thermal conductivity already is about equal to that of a monocrystalline layer of silicon.

It should further be noted that the use of metal wires in heat removal is known in itself. Thus, European Patent Application EP-A-0 082 051 describes a system for cooling electronical elements comprising a pattern of open coils of copper wire soldered to the heat sink of the element formed by a metal sheet. After fixation of the coils they may optionally be cut open, so as to leave a number of loose wires.

From U.S. Patent Specification US-A-4,450,505 a multichip module is known, where at the chips' back side bellows are fixed which are in connection with a space through which a coolant may be passed. A plurality of heat conducting strands extend from the bottom of each of the bellows and hence from a chip's back side into the space for the coolant.

Japanese Patent Application No. 58-200 560(A) describes a system for transferring heat from the chip to the heatsink by means of a flexible wire group that cannot transfer shearing stresses.

IBM Technical Disclosure Bulletin Vol. 21, No. 5, October 1978 (New York, USA) in its article "Brush-tipped Piston for Thermal Conduction" by R.G. Dessauer et al. (p. 1857) describes a different system, in which heat from a chip is transferred by way of the free ends of a bundle of wires of which the other ends are fixed in a spring pressure piston.

In Netherlands Patent Specification NL-C-110 715 is described a semiconductor body positioned in a housing and fitted with electrodes, in which the electrode heated most during operation has satisfactory thermal conductive contact with the housing which is of metal at least at the place of contact, with heat being dissipated across a layer of electrical insulating material provided between the metal housing and another component of metal. The construction in this case is such that the insulating layer of synthetic material, which contains, in a manner known in itself, grains of a powdered, high thermal conductive solid insulator, has a plurality of grains of about equal size, with such a small space being chosen between the metal components that the relative distance between the two metal components separated by the insulating layer is equal to the size of these grains.

Electronics & Power, Vol. 18, June 1972 (Hitchen, GB) in the article "Spherical diamond heatsinks" (see p. 235) notes that diamond particles are electrical insulating and thermal conductive. Because of these properties it is proposed that diamond particles provided in a substrate be used in a heatsink in printed circuits with electronic components.

In EP-A-0 065 686 a power device module is described with a dielectric substrate provided between the power device and the heat exchanger containing cooling ribs of aluminium. The dielectric substrate is attached to the aluminium heat exchanger with a structural adhesive containing a thermal conductive filler selected from the following group of materials: powdered aluminium, powdered copper, powdered silver, and powdered beryllia.

In European Patent Application EP-A-0 269 065 a semiconductor with cooling means of a different type is described. However, Fig. 4 of said specification shows that coolant supply channels having a decreasing cross-section in the coolant feed direction are known per se.

From none of the aforementioned publications a structure is known in which metal wires are assembled into appropriately shaped groups which in their turn are connected to metal foil baffles arranged in an appropriate pattern, such as according to the present invention.

The invention will be illustrated with reference to the schematic drawings.

Fig. 1 is a schematic view in cross-section through part of an embodiment of the module according to the invention.

Fig. 2 is an elevational view of part of the system of metal wires assembled into groups in the module according to the invention and provided with baffles in the form of strips of metal foil.

Fig. 3 is an elevational view of part of the module illustrated in Fig. 2 with the baffles left out.

Figs. 4, 5 and 6 are cross-sections of some cooling fin groups along the surfaces IV, V, and VI of Fig. 3.

Fig. 7 is a view in perspective on a greatly enlarged scale of some cooling fin groups.

Fig. 8 is a schematic top view of the baffles.

Fig. 9 is a schematic illustration of a stack of modules according to the invention.

Fig. 10 is a view in cross-section through part of the intermediate ply between metal sheet and chip in an embodiment of the module according to the invention.

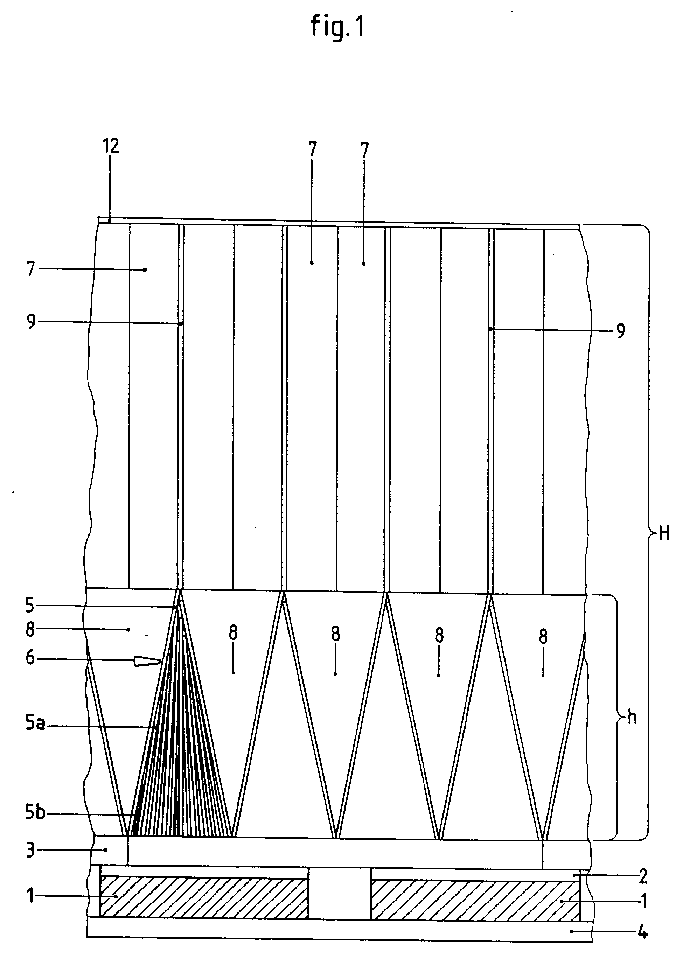

Fig. 1 is a schematic view in cross-section through part of an embodiment of the module according to the invention. In this embodiment a number of chips 1 (the actual number in a multichip module can be many tens to hundreds of chips) are fixed by way of an intermediate ply 2 to a heat sink formed by a spreader plate with high thermal conductivity, such as the metal sheet 3. In each chip a plurality of transistors or other electronic components are provided as is customary, and the electrical connections to these components are realised via a connecting layer 4. The nature and the construction of the layer 4 are extraneous to the present invention and may be of a conventional type known to the skilled man.

The heat generated in operation in the chips 1 is transferred via the intermediate ply 2, which according to the invention is at least composed of an electrical insulating and high thermal conductive layer and of which a highly appropriate embodiment will be dealt with hereinafter, to the metal sheet 3.
From there the heat is transferred further via the special construction according to the invention, which is by and large built up of the cooling fin groups which contain a plurality of metal wires and are provided at their crests with baffles of metal foil. Said construction is mounted to the metal sheet 3.

On the side facing away from the chips 1 there are mounted to the metal sheet 3 a plurality of wire cooling fins formed by metal wires 5, which wires 5 project from the surface of the metal sheet 3 as wires of a brush do. The metal wires, which may be of any suitable high thermal conductive material, such as copper or aluminium, have a diameter of, say, 0.1-0.2 mm and are fixed to the surface of the metal sheet, for instance by soldering, at regularly spaced intervals of, say, 0.1-0.7 mm. A "wire brush" may for instance be made by bundling copper wire onto which a soluble material has been extruded, cutting the plurality of strands into sheets of a thickness equal to the desired maximum length of the brush wires, soldering a thus formed sheet onto the metal sheet 3, and removing the soluble material by dissolution.

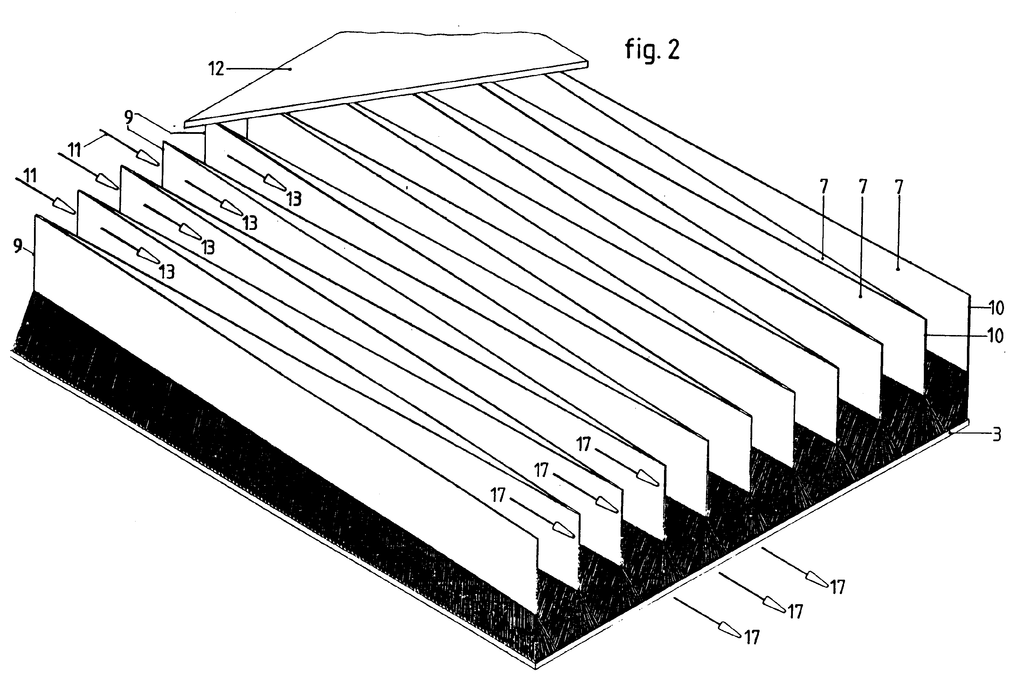

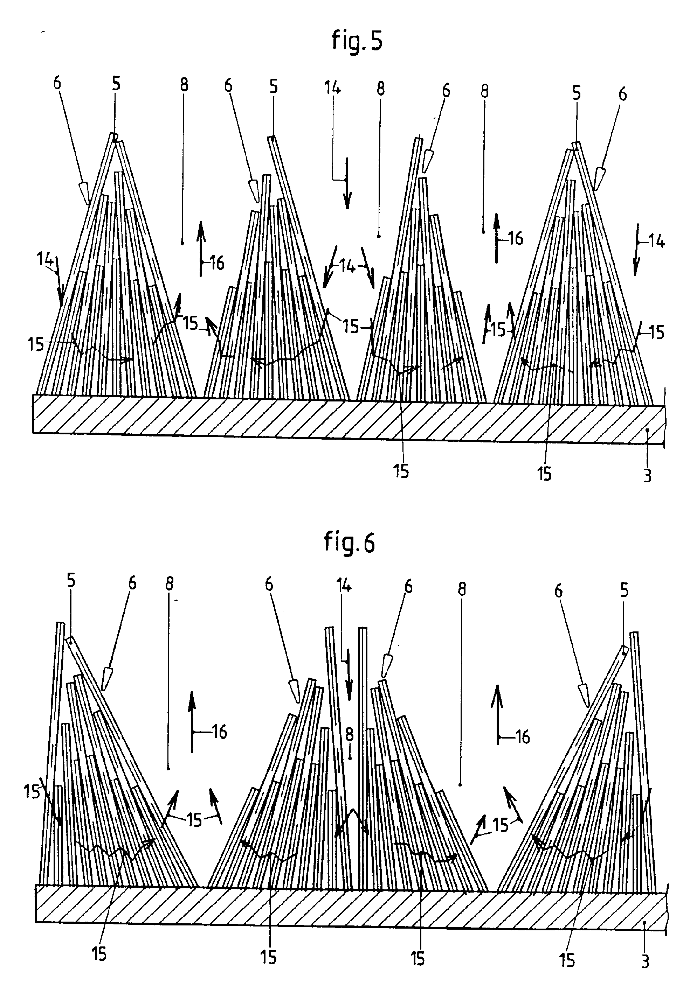

In a brush of metal wires 5 "grooves" are formed, for instance by etching, in which grooves the metal wires 5 consequently will be shorter than the adjoining wires. Long wires on either side of such "grooves" are then bent toward each other and connected by soldering, so forming the pattern of cooling fin groups 6 with a triangular cross-section and a height h, as illustrated in Fig. 1. As Fig. 1 shows, each of the groups 6 is built up of long wires 5 which generally are tapered on the outside and short to very short wires 5a and 5b, respectively, which are tapered more inward of the row. The pattern of cooling fin groups 6 built up of metal wires 5 will be discussed in more detail hereinafter with reference to the Figs. 2-7.

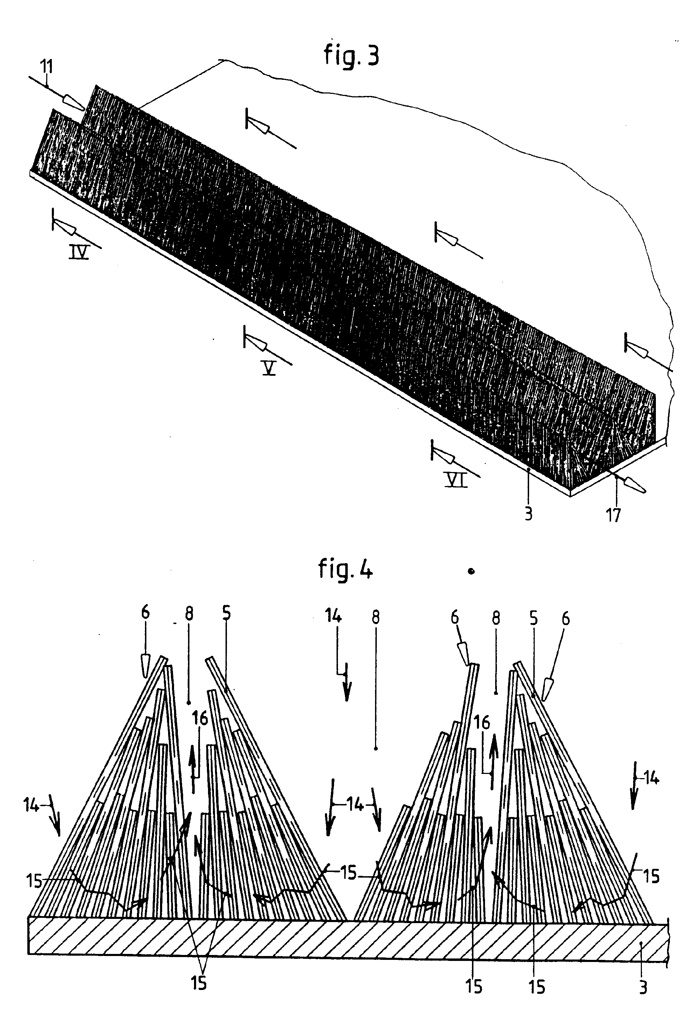

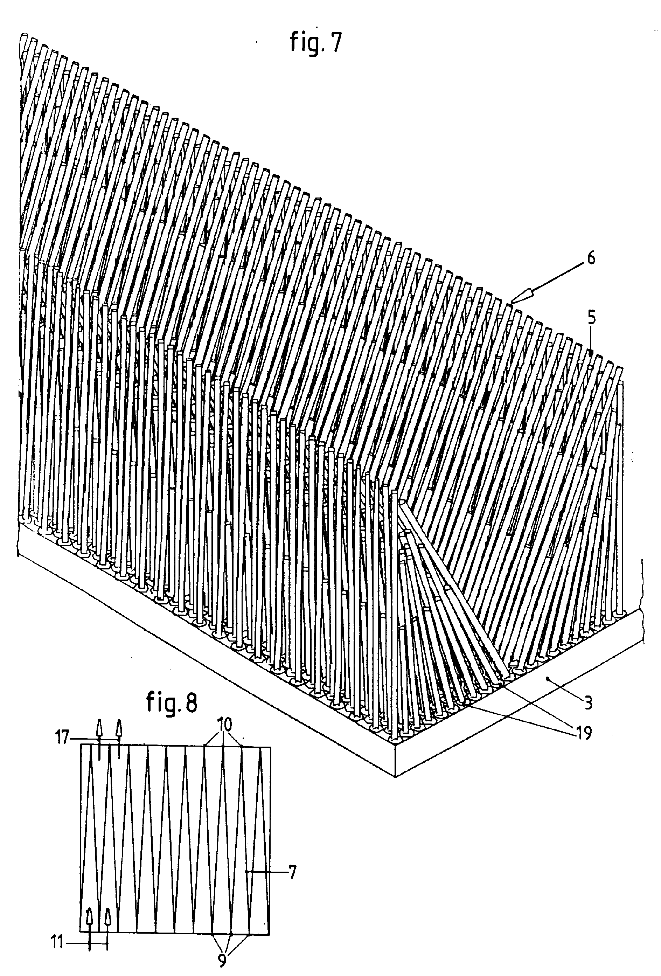

The crest of each cooling fin group 6 is connected to a foil 7 soldered to it, which projects upwards from that group in a direction by and large away from the metal sheet 3. The successive strips of foil 7, which are for instance of copper or aluminium of a thickness of the order of 0.1 mm, in addition are connected to each other in pairs by their front edges 9 and end edges 10, as is shown in Figs. 2 and 8. Consequently, the strips 7 form baffles for the coolant above the interspaces 8 between the cooling fin groups 6. At their top edges the baffles 7 are covered with a cover 12 attached to them, which may optionally consist of the bottom side of a next multichip module. Air or some other gaseous or liquid coolant is fed from an inlet (not shown) under an appropriate superatmospheric pressure along the direction of the arrows 11 to the air inlet channels between the baffles 7. Since the space between the baffles 7 in the direction of the arrows 13 gradually narrows, the cooling air is directly forced to flow downwards (see arrows 14 in Figs. 4, 5, and 6) through the interspaces 8 between the successive separated cooling fin groups 6. As also the interspaces 8 narrow in the direction of the arrows 13, the cooling air is forced to flow between the metal wires 5, 5a, and 5b of the cooling fin groups 6, approximately as indicated by the arrows 15. On leaving the cooling fin groups 6 the air heated by heat emission will move upwards again in the interspaces between successive cooling fin rows 6 as indicated by arrows 16 and move in the direction of the arrows 17 to the air outlet (not shown), i.e. under the influence of the widening in the direction of the arrows 17 of the interspaces 8 connected to the air outlet and the also widening space between the baffles 7. Since the coolant follows a labyrinthine path between the metal wires 5, 5a, and 5b when passing the cooling fin groups, particularly satisfactory cooling is effected.

Fig. 7 shows in top view part of the system of metal wires 5 assembled to form cooling fin groups 6 mounted to the metal sheet 3 at a stage prior to metal foil 7 being soldered to the crests of the groups. It is clear that the metal wires 5 are each soldered onto the metal sheet 3 by their foot 19 and arranged in regular rows. The cooling fin groups 6 and the baffles 7 are formed into a zig-zag pattern, as illustrated in Figs. 2, 3, and 8. A suitable width of the cooling fin groups 6 at their base, i.e. at the metal sheet 3 is, say, 2.5 mm. The height of the wire rows 6 and the baffles 7 together may be of the order of H = 10 mm in all (e.g. height h = 6 mm of the cooling fin or wire groups and on top thereof a further 4 mm for the baffles 7). The dimensions are given here only as an example: optimum values will need to be determined by a skilled man for every design and each envisaged coolant.

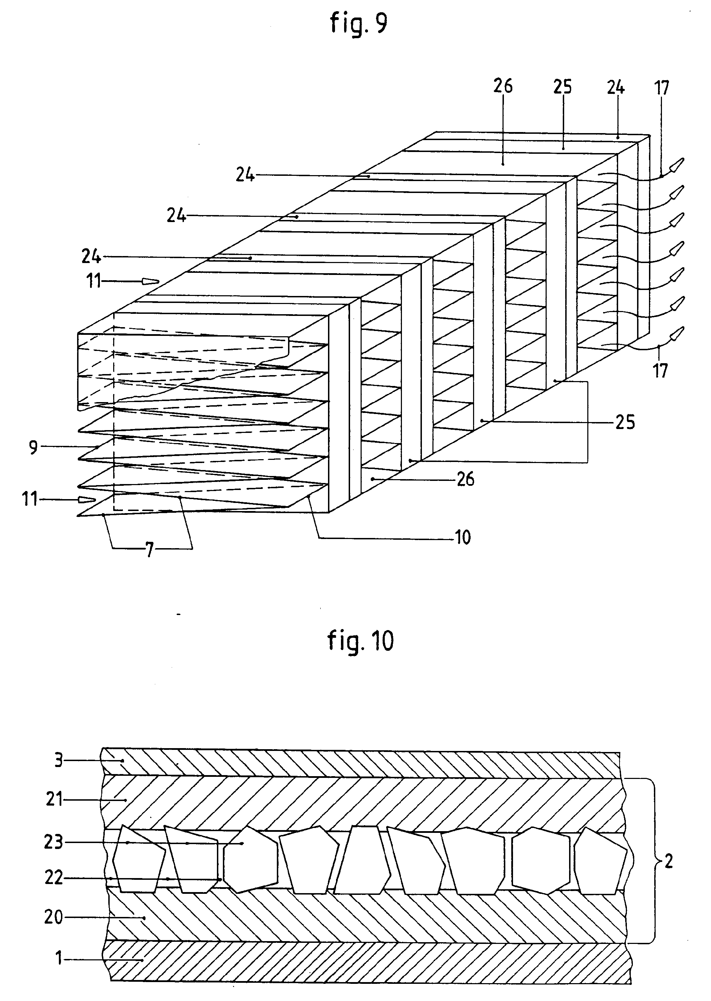

To ensure satisfactory heat dissipation it is of importance that the connection between chip 1 and metal sheet 3 (Fig. 1), i.e. the intermediate ply 2, should have high thermal conductive properties. According to the invention an intermediate ply having such favourable properties can be provided while the also desired property of electrical insulation of metal sheet 3 relative to chip 1 is retained. An embodiment of the device according to the invention having such an intermediate ply is shown in cross-section in Fig. 10 (as regards the essential portion). The intermediate ply 2, also called sandwich element, in such an embodiment is a layered or sandwich construction. Such a construction is built up of a thin layer 20 of a soft metal at the side of the chip 1 and a similar thin ply 21 of a soft metal at the side of metal sheet 3. The layers 20 and 21 are composed of a material selected from the following group of metals: aluminium, copper, nickel, gold, tin, and lead. In between the soft metal layers 20 and 21 of a thickness of 5-100 »m each there is an interface 22 of electrical insulating material. Embedded in layer 22, which may be of polymer, are diamond grains 23. The polymer in layer 22 may be selected from the following group of materials: polyepoxides, polyimides, polyamides, and polyesters. In thickness direction of the sandwich construction at least the greater part of the grains 23 have a dimension exceeding the thickness of the layer 22 in which they are embedded. The grains 23 therefore penetrate directly into the soft metal layers 20 and 21, respectively, at the bottom and the top. The average thickness of the interface 22, measured across the ends of the grains extending into the layers 20 and 21 is, e.g., 2-200 »m.

The size of the grains and the thickness of the layers 20, 21 and 22 are tailored to each other in such a way that the grains make direct contact with neither chip 1 nor metal sheet 3. The maximum thickness of the grains is, e.g., 2-200 »m and the material of the grains may be selected from the following group of materials: diamond, aluminium nitride, cubic boron nitride, and beryllium oxide.

The function of the soft metal layers in the described sandwich construction of the sandwich element is to conform to the surfaces of chip 1 and metal sheet 3, respectively. The function of the matrix or embedding material is to hold the construction together and to provide the required flexibility. The diamond grains (having a dimension of, say, 20 »m) provide the desired thermal conduction from chip 1 to metal sheet 3. Said grains have a thermal conductivity of, e.g., 50-2000 W/m·K and their specific electrical resistance R is 10¹⁰ to 10¹⁵ Ωm.

Fig. 9 is a schematic illustration of how in actual practice a number of modules according to the invention can be made into a stack. The disc-shaped parts 24 of each module in this case comprise the chips 1 and the connecting layer 4 and the disc-shaped parts 25 of each module comprise the sandwich element or intermediate ply 2, the metal sheet 3, and the cooling fin groups construction 6, i.e. as indicated in Fig. 1. As the arrows 11 indicate, cooling air is blown into the channels formed by the metal foil baffles 7. The package of metal foil baffles as a whole is always indicated with 26 and is positioned between the disc-shaped parts 24 and 25. After having carried out its cooling operation the air exits again on the other side of the stack, as indicated by the arrows 17.

The two examples below serve to illustrate the invention.

### Example 1

Use is made of a semiconductor module for a mainframe computer under the following selected conditions:
- The whole cooling device, i.e. the metal wires (5, 5a, 5b), the metal sheet 3, the metal foil baffles 7, and the sheets 20 and 21 are of copper.
- The coolant used is air.
- The overall height H (see Fig. 1) is 20 mm.
- The depth of the device, measured in longitudinal direction of the cooling fin rows 6 is 100 mm.
- The diameter of the wires 5, 5a, 5b is 0.1 mm.
- The difference in temperature between the incoming air and the chip junction is 50 K, which leads to a chip surface temperature of about 350 K.

Calculations based on the aforementioned starting data will give an optimum heat exchanger, of which the parameters mentioned hereinafter should have the values listed for them:
- The height h (see Fig. 1) of the fin rows 6 should be 6.5 mm, so that the height of the foil baffles 7 will be 13.5 mm.
- The centre distance between the wires (5, 5a, 5b) at their place of mounting to the metal sheet 3 (fin spacing) has to be 0.160 mm.
- The pitch of the fin rows 6 and the foil baffles 7 arranged in a zig-zag pattern, i.e. the space between the front edges 9 of two successive strips of foil, should be 2.7 mm.
- The ratio of pumping power, i.e. cooling air transfer power, to dissipated heat should be 0.4.

By using the parameters given in this example there is obtained a semiconductor module having a heat dissipation capacity of the order of 55W/cm², which it has to be stated is particularly favourable.

### Example 2

In the case of a semiconductor module intended for a personal computer a different criterion usually applies, viz. a low noise production level. This can be achieved by reducing the velocity of the coolant in the device to 1 m/sec. Again, the whole cooling device is assumed to be of copper and the coolant used ambient air. The overall height H and aforementioned depth of the device were both chosen to be 50 mm, and the difference in temperature between the incoming air and the chip surface again was 50 K. The height h of the fin rows 6 was 10 mm, so that the height of the foil baffles 7 was 40 mm. The diameter of the wires (5, 5a, 5b) was 0.200 mm, and the centre distance between them at their place of mounting to the metal sheet 3 was 0.400 mm. The desired pitch of the fin rows 6 and the foil baffles 7 arranged in a zig-zag pattern was 5 mm.
Calculations based on this data teach that said ratio of pumping power for cooling air to dissipated heat is 0.003.
By using the parameters given in this example there is obtained a semiconductor module which, while maintaining a low noise production level, achieves a heat dissipation capacity of the order of about 10W/cm², which it has to be stated is particularly favourable.

Within the scope of the invention various changes can be made. Notably, the wire elements need not have a circular diameter, but use may also be made of wires of any given other shape of diameter, for instance flat, polygonal, or lobate.

One of the surfaces between chip and heatsink may be lubricated, so that in thermal cycling the chip is not under stress. The chip may be continually pressed against the heat sink by a drop of silicone rubber on the active side. This drop functions also as the water scavenger.

## Claims

1. A heat exchanger for semiconductor elements comprising a heat dissipating conductor unit, such as a metal heat spreader plate (3), which is provided with a plurality of projecting closely spaced cooling fins of a high thermal conductive material, said cooling fins being positioned in cooling fin groups (6) separated from each other by a plurality of interspaces (8), said cooling fin groups being adapted to provide fluid communication between adjacent interspaces, and said interspaces alternately being inlets and outlets for the flow of coolant through said cooling fin groups such that an interspace which is an inlet is not directly connected to an outlet interspace and an interspace which is an outlet is not directly connected to an inlet interspace, whereby said cooling fin groups comprise closely spaced wires (5, 5a, 5b).

2. A heat exchanger according to claim 1, characterized in that measured transverse to the coolant feed direction the interspaces (8) that are inlets for the flow of coolant through the cooling wire groups (6) have a decreasing cross-section in the coolant feed direction (11), and the interspaces (8) that are outlets for the flow of coolant through the cooling wire groups (6) have an increasing cross-section in the coolant discharge direction (18).

3. A heat exchanger according to claim 1 or 2, characterized in that the cooling fin groups (6) are elongated and each consist of a plurality of cooling fins (5, 5a, 5b), which from their place of attachment (19) at the heat spreader plate (3) are oriented or bent toward each other in the plane transverse to the longitudinal direction of said groups.

4. A heat exchanger according to any one of the preceding claims, characterized in that the crests of adjacent cooling wire groups (6) extend relative to the heat spreader plate (3) by a zig-zag pattern.

5. A heat exchanger according to any one of the preceding claims, characterized in that the cooling fin groups (6) are elongated and there are positioned at the crest of the cooling fin groups (6) baffles (7) extending in longitudinal direction of the cooling fin groups (6), such that adjacent baffles (7), preferably consisting of strips or foil, together with said interspaces (8) form inlet and outlet channels for the coolant.

6. A semiconductor module comprised of at least one semiconductor chip (1), at least one heat dissipating conductor unit (2,3) connected to the back side of said semiconductor chip, and a plurality of closely spaced cooling fins of a high thermal conductive material, whereby the heat dissipating conductor unit and the cooling fins are contained in a heat exchanger according to claim 1, the cooling fins being attached to the side of the heat dissipating conductor unit facing away from said semiconductor chip, and said cooling fins projecting away from said semiconductor chip, wherein said cooling fins are positioned in cooling fin groups (6) separated from each other by interspaces (8) having a longitudinal direction substantially parallel to said heat dissipating conductor unit, said cooling fin groups being adapted to provide fluid communication between adjacent interspaces, said interspaces alternately being inlets and outlets for the flow of coolant through said cooling fin groups, said cooling fin groups comprising closely spaced wires (5, 5a, 5b).

7. A semiconductor module according to claim 6, characterized in that measured transverse to their longitudinal direction, the interspaces that are inlets for the flow of coolant through the cooling fin groups (6) have a decreasing cross-section in the coolant feed direction (13), and the interspaces (8) that are outlets for the flow of coolant through the cooling fin groups have an increasing cross-section in the coolant discharge direction (17).

8. A semiconductor module according to claim 6 or 7, characterized in that the cooling fin groups (6) each consist of a plurality of wire cooling fins (5, 5a, 5b), which from their place of attachment (19) at the heat spreader plate (3) are oriented or bent toward each other in the plane transverse to the longitudinal direction of the groups.

9. A semiconductor module according to claim 8, characterized in that the wire cooling fins (5, 5a, 5b) in a group oriented or bent toward each other are of different lengths and with their outer perimeter form a triangle, with the slants of the triangle bounding said interspaces (8).

10. A semiconductor module according to claim 6, characterized in that the wire cooling fins (5, 5a, 5b) of all cooling fin groups (6) are distributed uniformly at the surface of the heat sink (3).

11. A semiconductor module according to claim 6 or 10, characterized in that the crests of adjacent cooling fin groups (6) extend relative to the heat spreader plate (3) by a zig-zag pattern.

12. A semiconductor module according to claim 6, 10 or 11, characterized in that there is positioned at the crest of each of the cooling fin groups (6) a baffle (7) extending in longitudinal direction of the cooling fin groups, such that adjacent baffles, preferably consisting of strips of foil, together with said interspaces (8) form inlet or outlet channels for the coolant.

13. A semiconductor module according to claim 6, characterized in that, measured transverse to their longitudinal direction and at their place of attachment at the heat spreader plate (3), the maximum width of each of the cooling fin groups is less than the average length of the semiconductor chips (1).

14. A semiconductor module according to claim 6 intended to be used for cooling with a gaseous coolant, more particularly air, characterized in that said maximum width of each of the cooling fin groups (6) at the base is 3-9 mm.

15. A semiconductor module according to claim 6 intended to be used for cooling with a liquid coolant, more particularly water, characterized in that said maximum width of each of the cooling fin groups (6) at the base is 1-2 mm.

16. A semiconductor module according to claim 6, characterized in that the wire cooling fins (5, 5a, 5b) are mounted to the heat sink (3) at a relative centre distance of 0.05-3 mm.

17. A semiconductor module according to claim 6, characterized in that the wire cooling fins (5, 5a, 5b) have a diameter of at least 20 to 1000 »m.

18. A semiconductor module according to claim 12, characterized in that the distance h from the crest of the cooling fin groups (6) to the heat sink (3) has the value 0.05 H < h < H, wherein H is the distance from the top edge of the baffles (7) to the heat sink.

## Patentansprüche

1. Wärmetauscher für Halbleiterelemente mit einer wärmedissipierenden Leitereinheit, wie einer metallischen Wärmeverteilungsplatte (3), die mit einer Mehrzahl von abragenden, nahe beieinander liegenden Kühlflossen aus einem Material mit hoher Wärmeleitfähigkeit versehen sind, wobei die Kühlflossen in Kühlflossengruppen (6) angeordnet sind, die voneinander durch eine Mehrzahl von Zwischenräumen (8) getrennt sind, wobei die Kühlflossengruppen ausgebildet sind, um zwischen benachbarten Zwischenräumen eine Fluid-Kommunikation zu ermöglichen und wobei die Zwischenräume abwechselnd Einlässe und Auslässe für den Kühlmittelfluss durch die Kühlflossengruppen sind, derart, dass ein Einlass-Zwischenraum nicht direkt mit einem Auslass-Zwischenraum verbunden ist, und wobei ein Auslass-Zwischenraum nicht direkt mit einem Einlass-Zwischenraum verbunden ist, wobei die Kühlflossengruppen nahe beieinander liegende Drähte (5, 5a, 5b) enthalten.

2. Wärmetauscher nach Patentanspruch 1, dadurch gekennzeichnet, dass die Zwischenräume (8), die Einlässe für den Kühlmittelfluss durch die Kühldrahtgruppen (6) sind, quer zur Kühlmitteleinspeisungsrichtung gemessen einen in Kühlmittelspeisungsrichtung (11) abnehmenden Querschnitt besitzen, und dass die Zwischenräume (8), die Auslässe für den Kühlmittelfluss durch die Kühldrahtgruppen (6) sind, einen in Kühlmittelableitungsrichtung (18) zunehmenden Querschnitt haben.

3. Wärmetauscher nach Anspruch 1 oder 2, dadurch gekennzeichnet, dass die Kühlflossengruppen (6) länglich sind und jeweils aus einer Mehrzahl von Kühlflossen (5, 5a, 5b) bestehen, die vom Ort ihrer Befestigung (19) auf der Wärmeverteilungsplatte (3) in der Ebene quer zur Längsrichtung der Gruppen orientiert oder gegeneinander gebogen sind.

4. Wärmetauscher nach einem der vorangehenden Ansprüche, dadurch gekennzeichnet, dass sich der Kamm von benachbarten Kühldrahtgruppen (6) relativ zur Wärmeverteilungsplatte (3) zickzackförmig erstreckt.

5. Wärmetauscher nach einem der vorangehenden Ansprüche, dadurch gekennzeichnet, dass die Kühlflossengruppen (6) länglich sind und dass am Kamm der Kühlflossengruppen (6) Schikanen (7) angeordnet sind, die sich in Längsrichtung der Kühlflossengruppen (6) erstrecken, derart, dass benachbarte Schikanen (7), vorzugsweise aus Folienstreifen bestehend, zusammen mit den Zwischenräumen (8) Einlass- und Auslasskanäle für das Kühlmittel bilden.

6. Halbleitermodul mit mindestens einem Halbleiter-Chip (1), mindestens einer wärmedisspierenden Leiterplatte (2,3), die mit der Rückseite des Halbleiterchips verbunden ist, und einer Mehrzahl von nahe beieinander liegenden Kühlflossen aus einem Material mit hoher Wärmeleitfähigkeit, wobei die wärmedissipierende Leitereinheit und die Kühlflossen in einem Wärmetauscher nach Anspruch 1 enthalten sind, die Kühlflossen an der Seite der wärmedissipierenden Leitereinheit befestigt sind, die von dem Halbleiterchip abgekehrt ist, und wobei sich die Kühlflossen vom Halbleiterchip weg erstrecken, wobei die Kühlflossen in Kühlflossengruppen (6) angeordnet sind, die voneinander durch Zwischenräume (8) getrennt sind, deren Längsrichtung im wesentlichen parallel zu der wärmedissipierenden Leitereinheit liegt, wobei die Kühlflossengruppen ausgebildet sind, um zwischen benachbarten Zwischenräumen eine Fluid-Kommunikation zu ermöglichen, wobei die Zwischenräume abwechselnd Einlässe und Auslässe für den Kühlmittelfluss durch die Kühlflossengruppen sind und wobei die Kühlflossengruppen nahe beieinander liegende Drähte (5, 5a, 5b) enthalten.

7. Halbleitermodul nach Anspruch 6, dadurch gekennzeichnet, dass quer zu deren Längsrichtung gemessen die Zwischenräume, die Einlässe für den Kühlmittelfluss durch die Kühlflossengruppen (6) sind, in Kühlmitteleinspeisungsrichtung (13) einen abnehmenden Querschnitt haben und die Zwischenräume (8), die Auslässe für den Kühlmittelfluss durch die Kühlflossengruppen sind, in Kühlmittelabführungsrichtung (17) einen zunehmenden Querschnitt haben.

8. Halbleitermodul nach Anspruch 6 oder 7, dadurch gekennzeichnet, dass die Kühlflossengruppen (6) jeweils aus einer Mehrzahl von Drahtkühlflossen (5, 5a, 5b) bestehen, die vom Ort ihrer Befestigung (19) an der Wärmeverteilungsplatte (3) in der Ebene quer zur Längsrichtung der Gruppen orientiert oder gegeneinander gebogen sind .

9. Halbleitermodul nach Anspruch 8, dadurch gekennzeichnet, dass die Drahtkühlflossen (5, 5a, 5b) in der orientierten oder gegeneinander gebogenen Gruppe unterschiedliche Längen haben und an ihrem Aussenumfang ein Dreieck bilden, wobei die Schrägseiten des Dreiecks die Zwischenräume (8) begrenzen.

10. Halbleitermodul nach Anspruch 6, dadurch gekennzeichnet, dass die Drahtkühlflossen (5, 5a, 5b) aller Kühlflossengruppen (6) gleichmässig auf der Oberfläche des Wärmesumpfes (3) verteilt sind.

11. Halbleitermodul nach den Ansprüchen 6 oder 10, dadurch gekennzeichnet, dass sich die Kämme von benachbarten Kühlflossengruppen (6) relativ zur Wärmeverteilungsplatte (3) in einem zickzackförmigen Muster erstrecken.

12. Halbleitermodul nach Anspruch 6, 10 oder 11, dadurch gekennzeichnet, dass am Kamm jeder der Kühlflossengruppen (6) eine Schikane (7) angeordnet ist, die sich in Längsrichtung der Kühlflossengruppen erstreckt, so dass benachbarte Schikanen, vorzugsweise aus Folienstreifen bestehend, zusammen mit den Zwischenräumen (8) Einlass- oder Auslasskanäle für das Kühlmittel bilden.

13. Halbleitermodul nach Anspruch 6, dadurch gekennzeichnet, dass quer zur Längsrichtung gemessen und am Befestigungsort auf der Wärmeverteilungsplatte (3) die Maximalbreite jeder der Kühlflossengruppen kleiner als die mittlere Länge der Halbleiterchips (1) ist.

14. Halbleitermodul nach Anspruch 6 zur Verwendung für Kühlung mit einem gasförmigen Kühlmittel, insbesondere Luft, dadurch gekennzeichnet, dass die maximale Breite jeder der Kühlflossengruppen (6) an der Basis 3-9 mm beträgt.

15. Halbleitermodul nach Anspruch 6 zur Verwendung für Kühlung mit einem flüssigen Kühlmittel, insbesondere Wasser, dadurch gekennzeichnet, dass die maximale Breite jeder der Kühlflossengruppen (6) an der Basis 1-2 mm beträgt.

16. Halbleitermodul nach Anspruch 6, dadurch gekennzeichnet, dass die Drahtkühlflossen (5, 5a, 5b) mit einem relativen Mittelpunktsabstand von 0.05 bis 3 mm auf dem Wärmesumpf (3) befestigt sind.

17. Halbleitermodul nach Anspruch 6, dadurch gekennzeichnet, dass die Drahtkühlflossen (5, 5a, 5b) einen Durchmesser von mindestens 20 bis 1000 »m haben.

18. Halbleitermodul nach Anspruch 12, dadurch gekennzeichnet, dass der Abstand h zwischen dem Kamm der Kühlflossengruppen (6) und dem Wärmesumpf (3) einen Wert 0.05 H < h < H hat, worin H der Abstand zwischen der Oberkante der Schikanen (7) und dem Wärmesumpf ist.

## Revendications

1. Un échangeur de chaleur pour éléments à semiconducteur comprenant une unité conductrice de dissipation thermique, telle qu'une plaque métallique de diffusion thermique (3) qui est pourvue d'une pluralité d'ailettes de refroidissement en saillie, étroitement espacées, en matériau à haute conductibilité thermique, lesdites ailettes de refroidissement étant disposées par groupes d'ailettes de refroidissement (6) séparés les uns des autres par une pluralité d'intervalles (8), lesdits groupes d'ailettes de refroidissement (6) étant agencés pour établir une communication fluidique entre des intervalles adjacents, et lesdits intervalles constituant, alternativement, des entrées et des sorties pour le courant de réfrigérant à travers lesdits groupes d'ailettes de refroidissement de manière qu'un intervalle qui n'est pas une entrée ne soit pas directement relié à un intervalle de sortie et qu'un intervalle qui est une sortie ne soit pas directement relié à un intervalle d'entrée, dans lequel lesdits groupes d'ailettes de refroidissement comprennent des fils métalliques étroitement espacés (5, 5a, 5b).

2. Un échangeur de chaleur selon la revendication 1 caractérisé en ce que, mesurés transversalement à la direction d'alimentation du réfrigérant, les intervalles (8) qui constituent des entrées de courant de réfrigérant à travers les groupes d'ailettes de refroidissement (6) ont une section décroissante en coupe transversale, dans la direction d'alimentation du réfrigérant (11), et que les intervalles (8) qui constituent des sorties de courant de réfrigérant à travers les groupes d'ailettes de refroidissement (6) ont une section croissante en coupe transversale, dans la direction de décharge du réfrigérant (18).

3. Un échangeur de chaleur selon la revendication 1 ou 2, caractérisé en ce que les groupes d'ailettes de refroidissement (6) sont oblongs et que chacun d'eux est constitué par une pluralité d'ailettes de refroidissement (5, 5a, 5b) qui, à partir de leur emplacement de fixation (19) sur la plaque de diffusion thermique (3) sont orientées ou incurvées l'une vers l'autre dans le plan transversal à la direction longitudinale desdits groupes.

4. Un échangeur de chaleur selon l'une quelconque des précédentes revendications, caractérisé en ce que les sommets des groupes de fils de refroidissement adjacents (6) s'étendent par rapport à la plaque de diffusion thermique (3) en formant un dessin en zigzag.

5. Un échangeur de chaleur selon l'une quelconque des précédentes revendications, caractérisé en ce que les groupes d'ailettes de refroidissement (6) sont allongés et qu'il est positionné au sommet des groupes d'ailettes de refroidissement (6) des chicanes (7) s'étendant dans la direction longitudinale des groupes d'ailettes de refroidissement (6), de manière que les chicanes adjacentes (7), constituées de préférence par des bandes ou feuilles minces, avec lesdits intervalles (8) forment des canaux d'entrée et de sortie pour le réfrigérant.

6. Un module à semiconducteur comprenant au moins une puce à semiconducteur (1), au moins une unité conductrice de dissipation thermique (2, 3) reliée au dos de ladite puce à semiconducteur, et une pluralité d'ailettes de refroidissement étroitement espacées en matériau à haute conductibilité thermique, dans lequel l'unité conductrice de dissipation thermique et les ailettes de refroidissement sont contenues dans un échangeur de chaleur selon la revendication 1, les ailettes de refroidissement étant fixées sur le côté de l'unité conductrice de dissipation thermique tournant le dos à ladite puce semiconductrice, et lesdites ailettes de refroidissement faisant saillie en s'éloignant de ladite puce semiconductrice, dans lequel lesdites ailettes de refroidissement sont disposées dans des groupes d'ailettes de refroidissement (6) séparés les uns des autres par des intervalles (8) ayant une direction longitudinale sensiblement parallèle à ladite unité conductrice de dissipation thermique, lesdits groupes d'ailettes de refroidissement étant agencés pour établir une communication fluidique entre les intervalles adjacents, lesdits intervalles étant, alternativement, des entrées et des sorties de courant de réfrigérant à travers lesdits groupes d'ailettes de refroidissement, lesdits groupes d'ailettes de refroidissement comprenant des fils métalliques étroitement espacés (5, 5a, 5b).

7. Un module à semiconducteur selon la revendication 6, caractérisé en ce que, mesurés transversalement à leur direction longitudinale, les intervalles qui constituent des entrées de courant de réfrigérant traversant les groupes d'ailettes de refroidissement (6) ont une section décroissante en coupe transversale dans la direction d'alimentation du réfrigérant (12) et que les intervalles (8) qui constituent les sorties de courant de réfrigérant à travers les groupes d'ailettes de refroidissement ont une section croissante en coupe transversale, dans la direction d'évacuation du réfrigérant (17).

8. Un module à semiconducteur selon la revendication 6 ou 7, caractérisé en ce que les groupes d'ailettes de refroidissement (6) sont constitués individuellement par une pluralité d'ailettes de refroidissement en fil métallique (5, 5a, 5b) qui, à partir de leur emplacement de fixation (19) sur la plaque de diffusion thermique (3) sont orientées ou incurvées l'une vers l'autre dans le plan transversal à la direction longitudinale des groupes.

9. Un module à semiconducteur selon la revendication 8, caractérisé en ce que les ailettes de refroidissement en fil métallique (5, 5a, 5b) d'un groupe, orientées ou incurvées l'une vers l'autre, sont de longueurs différentes et que leur périmètre extérieur forme un triangle, les pentes du triangle constituant les limites desdits intervalles (8).

10. Un module à semiconducteur selon la revendication 6, caractérisé en ce que les ailettes de refroidissement en fil métallique (5, 5a, 5b) de tous les groupes d'ailettes de refroidissement (6) sont réparties uniformément à la surface du puits de chaleur (3).

11. Un module à semiconducteur selon la revendication 6 ou 10, caractérisé en ce que les sommets des groupes d'ailettes de refroidissement adjacents (6) s'étendent par rapport à la plaque de diffusion thermique (3) en formant un dessin en zigzag.

12. Un module à semiconducteur selon la revendication 6, 10 ou 11, caractérisé en ce qu'il est monté au sommet de chaque groupe d'ailettes de refroidissement (6) une chicane (7) s'étendant dans la direction longitudinale des groupes d'ailettes de refroidissement, de manière que les chicanes adjacentes, constituées de préférence par des bandes de feuilles minces, forment avec lesdits intervalles (8) des canaux d'entrée et de sortie pour le réfrigérant.

13. Un module à semiconducteur selon la revendication 6, caractérisé en ce que, mesurée transversalement à leur direction longitudinale et dans l'emplacement de montage sur la plaque de dissipation thermique (3), la largeur maximale de chacun des groupes d'ailettes de refroidissement est inférieure à la longueur moyenne des puces à semiconducteur (1).

14. Un module à semiconducteur selon la revendication 6 prévu pour être utilisé pour le refroidissement avec un réfrigérant gazeux, en particulier de l'air, caractérisé en ce que ladite largeur maximale à la base de chacun des groupes d'ailettes de refroidissement (6) est de 3 à 9 mm.

15. Un module à semiconducteur selon la revendication 6, prévu pour être utilisé pour le refroidissement avec un réfrigérant liquide, en particulier de l'eau, caractérisé en ce que ladite largeur maximale à la base de chacun des groupes d'ailettes de refroidissement (6) est de 1 à 2 mm.

16. Un module à semiconducteur selon la revendication 6, caractérisé en ce que les ailettes de refroidissement en fil métallique (5, 5a, 5b) sont montées sur le puits de chaleur (3) avec un entre-axe relatif de 0,05 à 3 mm.

17. Un module à semiconducteur selon la revendication 6, caractérisé en ce que les ailettes de refroidissement en fil métallique (5, 5a, 5b) ont un diamètre d'au moins 20 à 1000 micromètres.

18. Un module à semiconducteur selon la revendication 12, caractérisé en ce que la distance h, du sommet des groupes d'ailettes de refroidissement (6) au puits de chaleur (3) a une valeur 0,05 H < h < H, où H est la distance du bord supérieur des chicanes (7) au puits de chaleur.
